# EUROPEAN PATENT APPLICATION

(11) **EP 4 542 821 A1**
(43) Date of publication of application: **23.04.2025**
(21) Application number: 24205004.5
(22) Date of filing: 07.10.2024
(51) Int. Cl.: H02J 7/00

(54) **BATTERY PACK AND METHOD OF PROTECTING THE SAME**

(30) Priority: 17.10.2023 KR 20230138866
(71) Applicant: SAMSUNG SDI CO., LTD., Yongin-si, Gyeonggi-do 17084 (KR)
(72) Inventor: JEONG, Hyeoncheol, 17084 Yongin-si (KR)
(74) Representative: Marks & Clerk LLP

(57) **Abstract**

A battery pack includes battery cells between first and second pack terminals, balancing resistors respectively connected to the battery cells, balancing switches respectively connected to the battery cells and to the balancing resistors, and configured to form a closed circuit by connecting a corresponding one of the battery cells to a corresponding one of the balancing resistors, a rack fuse between the battery cells and the first pack terminal, or between the battery cells and the second pack terminal, a current sensor between the battery cells and the first pack terminal or the second pack terminal, and a controller configured to detect pack current between the first and second pack terminals through the current sensor, to control the balancing switches, and to detect a short-circuit between the first and second pack terminals based on the pack current and turn on all of the balancing switches.

## Description

### BACKGROUND

### 1. Field

One or more embodiments relate to a battery pack and a method of protecting the same.

### 2. Description of the Related Art

Secondary batteries are batteries that may be repeatedly charged and recharged, unlike non-rechargeable primary batteries. Small batteries are used in portable small electronic devices, such as smartphones, feature phones, laptop computers, digital cameras, and camcorders, whereas large batteries are widely used in hybrid vehicles, electric vehicles, and energy storage systems. Electric vehicle batteries are used as power sources to drive motors. In general, a large battery includes a battery cell, a battery module, and a battery pack.

A battery cell is a basic unit of a secondary battery that may be used by charging and discharging electrical energy, and includes an electrode assembly including a positive electrode and a negative electrode, a case in which the electrode assembly is accommodated, and an electrode terminal connected to the electrode assembly. A battery module is a battery assembly in which a certain number of battery cells are grouped together and put into a frame to protect the battery cells from external impact, heat, vibration, etc. A battery pack is a final battery system completed by mounting various control and protection systems, such as a battery management system (BSM) and a cooling system on battery modules. A battery module may be referred to as a battery block or a block, and a battery pack may be referred to as a battery rack or a rack.

A battery cell may include a cell fuse to protect the inside of the battery cell from overcurrent. Also, a battery pack may also include a main fuse to protect the battery pack from overcurrent, and the main fuse may be referred to as a rack fuse. If overcurrent occurs due to a short-circuit at a load end or an output end, the rack fuse usually blows first. However, if the cell fuse blows before the rack fuse, a reverse voltage exceeding a withstand voltage may be applied to the battery cell. An electric arc may occur in the battery cell, and there is a risk that the battery cell may ignite.

The above information disclosed in this Background section is only for enhancement of understanding of the background of the present disclosure, and therefore, it may contain information that does not constitute the related art.

### SUMMARY

One or more embodiments include a battery pack capable of protecting a battery cell even if a relatively large reverse voltage is applied to the battery cell due to a blowout of a cell fuse.

One or more embodiments include a method of protecting a battery pack, which may protect a battery cell even if a relatively large reverse voltage is applied to the battery cell due to a blowout of a cell fuse.

However, aspects of the present disclosure are not limited thereto, and other aspects will be understood by one of ordinary skill in the art from the following description of the present disclosure.

Additional aspects will be set forth in part in the description which follows and, in part, will be apparent from the description, or may be learned by practice of the presented embodiments of the present disclosure.

According to one or more embodiments, a battery pack includes battery cells between a first pack terminal and a second pack terminal, balancing resistors respectively connected to the battery cells, balancing switches respectively connected to the battery cells and to the balancing resistors, and configured to form a closed circuit by connecting a corresponding one of the battery cells to a corresponding one of the balancing resistors, a rack fuse between the battery cells and the first pack terminal, or between the battery cells and the second pack terminal, a current sensor between the battery cells and the first pack terminal, or between the battery cells and the second pack terminal, and a controller configured to detect pack current between the first pack terminal and the second pack terminal through the current sensor, to control the balancing switches, and to detect a short-circuit between the first pack terminal and the second pack terminal based on the pack current and turn on all of the balancing switches.

The battery cells may include a first cell terminal and a second cell terminal, an electrode assembly including a positive electrode connected to the first cell terminal, a negative electrode connected to the second cell terminal, and a separator between the positive electrode and the negative electrode, and a cell fuse between the electrode assembly and the first cell terminal, or between the electrode assembly and the second cell terminal.

The controller may be further configured to detect the short-circuit based on the pack current exceeding a reference value.

The controller may be further configured to determine whether the rack fuse blows based on detecting that the short-circuit is cleared in a state where all of the balancing switches are turned on.

The controller may be further configured to detect that the short-circuit is cleared based on the pack current being reduced to a level that is equal to or less than the reference value.

The controller may be further configured to turn off all of the balancing switches based on the rack fuse not being blown.

The battery pack may further include battery blocks connected between the first pack terminal and the second pack terminal, and including corresponding ones of the battery cells, balancing circuits respectively including the balancing resistors and the balancing switches, block control circuits configured to respectively control the balancing switches, and a main controller configured to detect the pack current, to detect a state of the rack fuse, and to control the block control circuits.

The controller may include the block control circuits and the main controller.

The main controller may be further configured to transmit to the block control circuits a command to turn on all of the balancing switches based on the short-circuit.

The block control circuits may be configured to detect cell voltages of the battery cells of a respective one of the battery blocks, and to control the balancing switches of a respective one of the balancing circuits to equalize the cell voltages of the battery cells.

According to a method of protecting a battery pack according to one or more embodiments, in which the battery pack includes battery cells between a first pack terminal and a second pack terminal, balancing resistors respectively connected to the battery cells, balancing switches respectively connected to the battery cells and the balancing resistors and configured to form a closed circuit by connecting a corresponding one of the battery cells to a corresponding one of the balancing resistors by turning on, a rack fuse between the battery cells and the first pack terminal or the second pack terminal, a current sensor between the battery cells and the first pack terminal or the second pack terminal, and a controller configured to control the balancing switches, the method includes detecting pack current between the first pack terminal and the second pack terminal through the current sensor, detecting a short-circuit between the first pack terminal and the second pack terminal based on the pack current, and turning on all of the balancing switches based on detection of the short-circuit.

The detecting of the short-circuit may include comparing the pack current with a reference value, and determining the pack current exceeds the reference value.

The method may further include detecting the short-circuit is cleared and that all of the balancing switches are turned on, and determining whether the rack fuse blows.

The detecting the short-circuit is cleared may include comparing the pack current with the reference value, and determining the pack current is reduced to a level equal to or less than the reference value.

The method may further include determining the rack fuse does not blow, and turning off all of the balancing switches.

The battery cells may include a first cell terminal and a second cell terminal, an electrode assembly including a positive electrode connected to the first cell terminal, a negative electrode connected to the second cell terminal, and a separator between the positive electrode and the negative electrode, and a cell fuse between the electrode assembly and the first cell terminal or the second cell terminal.

At least some of the above and other features of the invention are set out in the claims.

### BRIEF DESCRIPTION OF THE DRAWINGS

The accompanying drawings illustrate preferred embodiments of the present disclosure and together with the foregoing disclosure, serve to provide further understanding of the aspects of the present disclosure, and thus, the present disclosure is not construed as being limited to the drawings, in which:
FIG. 1 is a block diagram illustrating a battery pack, according to embodiments of the present disclosure;
FIG. 2 is a flowchart for describing a method of protecting a battery pack, according to embodiments of the present disclosure;
FIG. 3 is a block diagram illustrating a battery pack, according to other embodiments of the present disclosure;
FIG. 4 illustrates one block of the battery pack of FIG. 3;
FIGS. 5A and 5B are respectively a perspective view and a cross-sectional view illustrating a cylindrical battery cell mounted on a battery pack, according to embodiments of the present disclosure;
FIG. 6 is a partial perspective view illustrating a structure of a pouch-type battery cell mounted on a battery pack, according to embodiments of the present disclosure;
FIG. 7A is a perspective view illustrating a prismatic battery cell mounted on a battery pack, according to embodiments of the present disclosure; and FIG. 7B is a cross-sectional view taken along the line II-II of FIG. 7A.

### DETAILED DESCRIPTION

Aspects of some embodiments of the present disclosure and methods of accomplishing the same may be understood more readily by reference to the detailed description of embodiments and the accompanying drawings. The described embodiments are provided as examples so that this disclosure will be thorough and complete, and will fully convey the aspects of the present disclosure to those skilled in the art. Accordingly, processes, elements, and techniques that are redundant, that are unrelated or irrelevant to the description of the embodiments, or that are not necessary to those having ordinary skill in the art for a complete understanding of the aspects of the present disclosure may be omitted. Unless otherwise noted, like reference numerals, characters, or combinations thereof denote like elements throughout the attached drawings and the written description, and thus, repeated descriptions thereof may be omitted.

The described embodiments may have various modifications and may be embodied in different forms, and should not be construed as being limited to only the illustrated embodiments herein. The use of "can," "may," or "may not" in describing an embodiment corresponds to one or more embodiments of the present disclosure. The present disclosure covers all modifications, equivalents, and replacements within the idea and technical scope of the present disclosure. Further, each of the features of the various embodiments of the present disclosure may be combined with each other, in part or in whole, and technically various interlocking and driving are possible. Each embodiment may be implemented independently of each other or may be implemented together in an association.

In the drawings, the relative sizes of elements, layers, and regions may be exaggerated for clarity and/or descriptive purposes. Additionally, the use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, property, etc., of the elements, unless specified.

Various embodiments are described herein with reference to sectional illustrations that are schematic illustrations of embodiments and/or intermediate structures. As such, variations from the shapes of the illustrations as a result of, for example, manufacturing techniques and/or tolerances, are to be expected. Further, specific structural or functional descriptions disclosed herein are merely illustrative for the purpose of describing embodiments according to the concept of the present disclosure. Thus, embodiments disclosed herein should not be construed as limited to the illustrated shapes of elements, layers, or regions, but are to include deviations in shapes that result from, for instance, manufacturing.

Spatially relative terms, such as "beneath," "below," "lower," "lower side," "under," "above," "upper," "upper side," and the like, may be used herein for ease of explanation to describe one element or feature's relationship to another element(s) or feature(s) as illustrated in the figures. It will be understood that the spatially relative terms are intended to encompass different orientations of the device in use or in operation, in addition to the orientation depicted in the figures. For example, if the device in the figures is turned over, elements described as "below," "beneath," "or "under" other elements or features would then be oriented "above" the other elements or features. Thus, the example terms "below" and "under" can encompass both an orientation of above and below. The device may be otherwise oriented (e.g., rotated 90 degrees or at other orientations) and the spatially relative descriptors used herein should be interpreted accordingly. Similarly, when a first part is described as being arranged "on" a second part, this indicates that the first part is arranged at an upper side or a lower side of the second part without the limitation to the upper side thereof on the basis of the gravity direction.

Further, the phrase "in a plan view" means when an object portion is viewed from above, and the phrase "in a schematic cross-sectional view" means when a schematic cross-section taken by vertically cutting an object portion is viewed from the side. The terms "overlap" or "overlapped" mean that a first object may be above or below or to a side of a second object, and vice versa. Additionally, the term "overlap" may include stack, face or facing, extending over, covering, or partly covering or any other suitable term as would be appreciated and understood by those of ordinary skill in the art. The expression "not overlap" may include meaning, such as "apart from" or "set aside from" or "offset from" and any other suitable equivalents as would be appreciated and understood by those of ordinary skill in the art. The terms "face" and "facing" may mean that a first object may directly or indirectly oppose a second object. In a case in which a third object intervenes between a first and second object, the first and second objects may be understood as being indirectly opposed to one another, although still facing each other.

It will be understood that when an element, layer, region, or component is referred to as being "formed on," "on," "connected to," or "(operatively or communicatively) coupled to" another element, layer, region, or component, it can be directly formed on, on, connected to, or coupled to the other element, layer, region, or component, or indirectly formed on, on, connected to, or coupled to the other element, layer, region, or component such that one or more intervening elements, layers, regions, or components may be present. In addition, this may collectively mean a direct or indirect coupling or connection and an integral or non-integral coupling or connection. For example, when a layer, region, or component is referred to as being "electrically connected" or "electrically coupled" to another layer, region, or component, it can be directly electrically connected or coupled to the other layer, region, and/or component or one or more intervening layers, regions, or components may be present. The one or more intervening components may include a switch, a resistor, a capacitor, and/or the like. In describing embodiments, an expression of connection indicates electrical connection unless explicitly described to be direct connection, and "directly connected/directly coupled," or "directly on," refers to one component directly connecting or coupling another component, or being on another component, without an intermediate component.

In addition, in the present specification, when a portion of a layer, a film, an area, a plate, or the like is formed on another portion, a forming direction is not limited to an upper direction but includes forming the portion on a side surface or in a lower direction. On the contrary, when a portion of a layer, a film, an area, a plate, or the like is formed "under" another portion, this includes not only a case where the portion is "directly beneath" another portion but also a case where there is further another portion between the portion and another portion. Meanwhile, other expressions describing relationships between components, such as "between," "immediately between" or "adjacent to" and "directly adjacent to," may be construed similarly. It will be understood that when an element or layer is referred to as being "between" two elements or layers, it can be the only element or layer between the two elements or layers, or one or more intervening elements or layers may also be present.

For the purposes of this disclosure, expressions such as "at least one of," or "any one of," or "one or more of" when preceding a list of elements, modify the entire list of elements and do not modify the individual elements of the list. For example, "at least one of X, Y, and Z," "at least one of X, Y, or Z," "at least one selected from the group consisting of X, Y, and Z," and "at least one selected from the group consisting of X, Y, or Z" may be construed as X only, Y only, Z only, any combination of two or more of X, Y, and Z, such as, for instance, XYZ, XYY, YZ, and ZZ, or any variation thereof. Similarly, the expressions "at least one of A and B" and "at least one of A or B" may include A, B, or A and B. As used herein, "or" generally means "and/or," and the term "and/or" includes any and all combinations of one or more of the associated listed items. For example, the expression "A and/or B" may include A, B, or A and B. Similarly, expressions such as "at least one of," "a plurality of," "one of," and other prepositional phrases, when preceding a list of elements, modify the entire list of elements and do not modify the individual elements of the list.

It will be understood that, although the terms "first," "second," "third," etc., may be used herein to describe various elements, components, regions, layers and/or sections, these elements, components, regions, layers and/or sections should not be limited by these terms. These terms do not correspond to a particular order, position, or superiority, and are only used to distinguish one element, member, component, region, area, layer, section, or portion from another element, member, component, region, area, layer, section, or portion. Thus, a first element, component, region, layer or section described below could be termed a second element, component, region, layer or section, without departing from the scope of the present disclosure. The description of an element as a "first" element may not require or imply the presence of a second element or other elements. The terms "first," "second," etc. may also be used herein to differentiate different categories or sets of elements. For conciseness, the terms "first," "second," etc. may represent "first-category (or first-set)," "second-category (or second-set)," etc., respectively.

The terminology used herein is for the purpose of describing embodiments only and is not intended to be limiting of the present disclosure. As used herein, the singular forms "a" and "an" are intended to include the plural forms as well, while the plural forms are also intended to include the singular forms, unless the context clearly indicates otherwise. It will be further understood that the terms "comprises," "comprising," "have," "having," "includes," and "including," when used in this specification, specify the presence of the stated features, integers, steps, operations, elements, and/or components, but do not preclude the presence or addition of one or more other features, integers, steps, operations, elements, components, and/or groups thereof.

When one or more embodiments may be implemented differently, a specific process order may be performed differently from the described order. For example, two consecutively described processes may be performed substantially at the same time or performed in an order opposite to the described order.

As used herein, the term "substantially," "about," "approximately," and similar terms are used as terms of approximation and not as terms of degree, and are intended to account for the inherent deviations in measured or calculated values that would be recognized by those of ordinary skill in the art. For example, "substantially" may include a range of +/- 5 % of a corresponding value. "About" or "approximately," as used herein, is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within ± 30%, 20%, 10%, 5% of the stated value. Further, the use of "may" when describing embodiments of the present disclosure refers to "one or more embodiments of the present disclosure."

In some embodiments well-known structures and devices may be described in the accompanying drawings in relation to one or more functional blocks (e.g., block diagrams), units, and/or modules to avoid unnecessarily obscuring various embodiments. Those skilled in the art will understand that such block, unit, and/or module are/is physically implemented by a logic circuit, an individual component, a microprocessor, a hard wire circuit, a memory element, a line connection, and other electronic circuits. This may be formed using a semiconductor-based manufacturing technique or other manufacturing techniques. The block, unit, and/or module implemented by a microprocessor or other similar hardware may be programmed and controlled using software to perform various functions discussed herein, optionally may be driven by firmware and/or software. In addition, each block, unit, and/or module may be implemented by dedicated hardware, or a combination of dedicated hardware that performs some functions and a processor (for example, one or more programmed microprocessors and related circuits) that performs a function different from those of the dedicated hardware. In addition, in some embodiments, the block, unit, and/or module may be physically separated into two or more interacting individual blocks, units, and/or modules without departing from the scope of the present disclosure. In addition, in some embodiments, the block, unit and/or module may be physically combined into more complex blocks, units, and/or modules without departing from the scope of the present disclosure.

Unless otherwise defined, all terms (including technical and scientific terms) used herein have the same meaning as commonly understood by one of ordinary skill in the art to which the present disclosure belongs. It will be further understood that terms, such as those defined in commonly used dictionaries, should be interpreted as having a meaning that is consistent with their meaning in the context of the relevant art and/or the present specification, and should not be interpreted in an idealized or overly formal sense, unless expressly so defined herein.

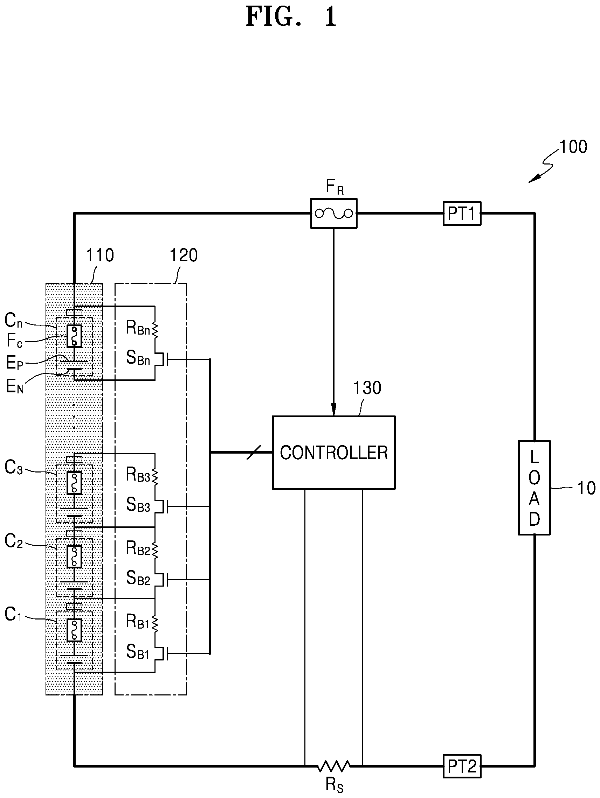

FIG. 1 is a block diagram illustrating a battery pack, according to embodiments of the present disclosure.

Referring to FIG. 1, a battery pack 100 includes a battery 110, a balancing circuit 120, and a controller 130 between first and second pack terminals PT1 and PT2. The battery pack 100 may be connected to a load 10 through the first and second pack terminals PT1 and PT2, and may supply energy stored in the battery 110 to the load 10. Instead of the load 10, a charging device may be connected to the first and second pack terminals PT1 and PT2, and the charging device may supply energy for charging the battery 110.

The battery pack 100 further includes a rack fuse F_{R}. The rack fuse F_{R} may be connected between the battery 110 and the first pack terminal PT1. According to one or more other embodiments, the rack fuse F_{R} may be connected between the battery 110 and the second pack terminal PT2.

The rack fuse F_{R} blows if current equal to or greater than a corresponding amount (e.g., a preset amount) flows to block a high current path through the battery 110. If the rack fuse F_{R} blows, a relatively large reverse voltage may be applied to both ends of the rack fuse F_{R}, and the rack fuse F_{R} has a withstand voltage sufficient to withstand a relatively large reverse voltage. If a reverse voltage exceeding the withstand voltage of the rack fuse F_{R} is applied, an electric arc may occur between both terminals of the rack fuse F_{R} that blows, a fire may occur, and internal elements may be damaged.

The controller 130 may detect a state of the rack fuse F_{R}. For example, the controller 130 may determine whether the rack fuse F_{R} has blown. For example, the controller 130 may determine a state of the rack fuse F_{R} based on a potential difference between both ends of the rack fuse F_{R}.

In one or more embodiments, the battery pack 100 may include a switch between the battery 110 and the first or second pack terminals PT1 or PT2, and the controller 130 may control opening and closing of the switch. The switch may include a charge control switch and a discharge control switch. If the charge control switch is opened, the battery 110 may be discharged, but charging of the battery 110 is blocked. If the discharge control switch is opened, the battery 110 may be charged, but discharging of the battery 110 is blocked. The switch may be, for example, a relay switch.

The battery pack 100 includes a current sensor for detecting discharge current discharged from the battery 110, and for detecting charge current for charging the battery 110. The discharge current and the charge current of the battery 110 are referred to as pack current. According to embodiments, the current sensor may be a shunt resistor Rs between the battery 110 and the second pack terminal PT2. In one or more embodiments, the shunt resistor Rs may be connected between the battery 110 and the first pack terminal PT1.

The controller 130 may detect a magnitude of pack current based on a voltage at both ends of the shunt resistor Rs The controller 130 may detect pack current by using the shunt resistor Rs, and may detect a short-circuit between the first and second pack terminals PT1 and PT2 based on the pack current. For example, if the controller 130 detects pack current exceeding a corresponding reference value (e.g., a preset reference value), the controller 130 may determine that a short-circuit has occurred between the first and second pack terminals PT1 and PT2.

The battery 110 may include a plurality of battery cells C₁, C₂, C₃, ..., and Cₙ. The battery cells C₁, C₂, C₃, ..., and Cₙ are portions storing power, and may be rechargeable secondary batteries. For example, the battery cells C₁, C₂, C₃, ..., and Cₙ may include at least one selected from the group comprising a lithium ion battery, a lithium polymer battery, a nickel cadmium battery, a nickel metal hydride battery (Ni-MH), a nickel-zinc battery (Ni-Zn), or a lead storage battery.

The battery cells C₁, C₂, C₃, ..., and Cₙ may be connected in series between the first and second pack terminals PT1 and PT2 as shown in FIG. 1. However, this is merely an example, and the number and connection configuration of the battery cells C₁, C₂, C₃, ..., and Cₙ may be determined according to an output voltage and power storage capacity suitable for the battery pack 100. Each of the battery cells C₁, C₂, C₃, ..., and Cₙ may be referred to as a battery cell C.

The battery cell C may include an electrode assembly and a cell fuse Fc connected in series between first and second cell terminals. The electrode assembly may include a positive electrode E_{P} connected to the first cell terminal, a negative electrode E_{N} connected to the second cell terminal, and a separator located between the positive electrode E_{P} and the negative electrode E_{N} to separate the positive electrode E_{P} and the negative electrode E_{N} from contacting each other. The first cell terminal may be a positive electrode terminal of the battery cell C, and the second cell terminal of a negative electrode terminal of the battery cell C.

The cell fuse Fc blows if current equal to or greater than a corresponding amount (e.g., a preset amount) flows to block a current path through the battery cell C, thereby reducing or preventing a risk of, for example, ignition or explosion of the electrode assembly in the battery cell C.

If a short-circuit occurs between the first and second pack terminals PT1 and PT2 of the battery pack 100 of FIG. 1, for example, the load 10 with a short-circuit is connected between the first and second pack terminals PT1 and PT2, relatively large pack current is generated. If relatively large pack current is generated due to a short-circuit, the rack fuse F_{R} generally having a high withstand voltage blows first. However, if any one of the cell fuses Fc of the battery cells C₁, C₂, C₃, ..., and Cₙ blows before the rack fuse F_{R}, a relatively large reverse voltage is generated at both ends of the cell fuse Fc that blows.

A magnitude of a reverse voltage may be large enough to correspond to a magnitude of a total voltage of the battery cells C₁, C₂, C₃, ..., and Cₙ (e.g., a pack voltage between the first and second pack terminals PT1 and PT2). For example, if resistance between the first and second pack terminals PT1 and PT2 is about 0 due to a short-circuit, a reverse voltage corresponding to a magnitude of a pack voltage is applied to both ends of the cell fuse Fc that blows. This relatively large reverse voltage may exceed a withstand voltage of the cell fuse Fc, and the reverse voltage exceeding the withstand voltage of the cell fuse Fc that blows may generate an arc in the cell fuse Fc that blows. Due to the arc, the separator of the corresponding battery cell C may be damaged, and the positive electrode E_{P} and the negative electrode E_{N} of the electrode assembly may contact each other. The battery cell C may even ignite or explode.

Even if a short-circuit occurs between the first and second pack terminals PT1 and PT2, and if any one of the cell fuses Fc blows before the rack fuse F_{R} blows, the battery pack 100 of the present disclosure may reduce or prevent the likelihood of a reverse voltage exceeding a withstand voltage being generated at both ends of the cell fuse F_{C} that blows.

The balancing circuit 120 includes a plurality of balancing resistors R_{B1}, R_{B2}, R_{B3}, ..., and R_{Bn} and a plurality of balancing switches S_{B1}, S_{B2}, S_{B3}, ..., and S_{Bn} respectively connected to the plurality of battery cells C₁, C₂, C₃, ..., and Cₙ. Each of the balancing switches S_{B1}, S_{B2}, S_{B3}, ..., and S_{Bn} is connected to a corresponding battery cell from among the battery cells C₁, C₂, C₃, ..., and Cₙ and to a corresponding balancing resistor from among the balancing resistors R_{B1}, R_{B2}, R_{B3}, ..., and Ran. If each of the balancing switches S_{B1}, S_{B2}, S_{B3}, ..., and S_{Bn} is turned on, the corresponding battery cell and the corresponding balancing resistor may be connected to form a closed circuit.

As shown in FIG. 1, a positive electrode terminal and a negative electrode terminal of the first battery cell C₁ are connected to each other through the first balancing resistor R_{B}, and the first balancing switch S_{B1}, which are connected in series. If the first balancing switch S_{B1} is turned on, the first battery cell C₁ and the first balancing resistor R_{B1} form a closed circuit, and both terminals of the first battery cell C₁ are directly connected to respective ends of the first balancing resistor R_{B1}.

For example, if a cell voltage of the first battery cell C₁ is higher than cell voltages of the other battery cells C₂, C₃, ..., and Cₙ, the first balancing switch S_{B1} may be turned on by the controller 130, energy stored in the first battery cell C₁ may be consumed through the first balancing resistor R_{B1}, and the cell voltage of the first battery cell C₁ may be lowered to be similar to the cell voltages of the other battery cells C₂, C₃, ..., and Cₙ.

The controller 130 may be configured to detect pack current flowing through the battery 110 between the first and second pack terminals PT1 and PT2 through the current sensor and control the balancing switches S_{B1}, S_{B2}, S_{B3}, ..., and S_{Bn}. The controller 130 may detect a state of the rack fuse F_{R}. According to the present disclosure, if the controller 130 may be configured to turn on all of the balancing switches S_{B1}, S_{B2}, S_{B3}, ..., and S_{Bn} a short-circuit between the first and second pack terminals PT1 and PT2 may be detected based on pack current.

If the rack fuse F_{R} blows first due to a short-circuit, because the rack fuse F_{R} is designed to have a higher withstand voltage than a reverse voltage corresponding to a pack voltage, the battery pack 100 may be safely protected. However, even if any one of the cell fuses Fc (e.g., the cell fuse Fc of the first battery cell C₁) blows before the rack fuse F_{R}, because all of the balancing switches S_{B1}, S_{B2}, S_{B3}, ..., and S_{Bn} are turned on under the control of the controller 130, a reverse voltage applied to the first battery cell C₁ is applied across both ends of the first balancing resistor R_{B1}, thereby reducing or preventing the likelihood of an arc occurring in the cell fuse Fc of the first battery cell C₁.

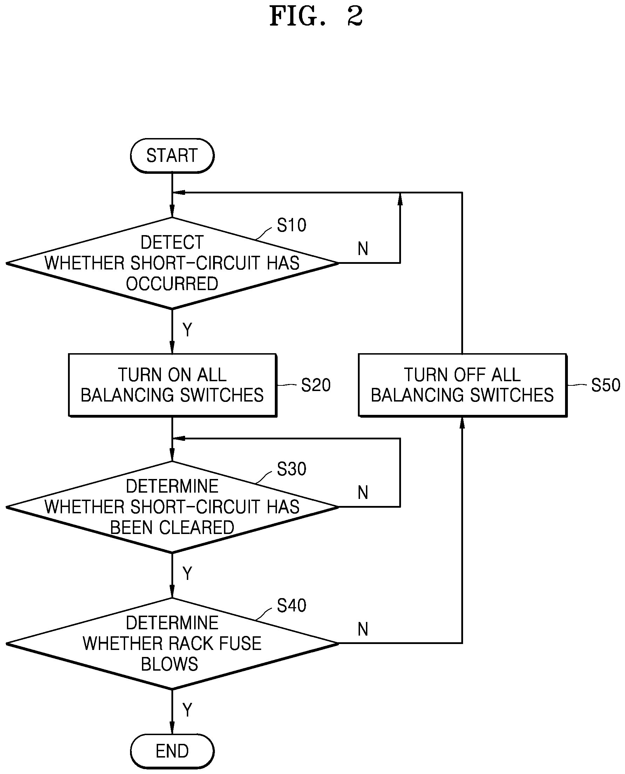

FIG. 2 is a flowchart for describing a method of protecting a battery pack, according to embodiments of the present disclosure.

Referring to FIG. 2 together with FIG. 1, the controller 130 may detect a magnitude of pack current through a voltage at both ends of the shunt resistor R_{S}, and may detect that whether a short-circuit has occurred between the first and second pack terminals PT1 and PT2 through the pack current exceeding a corresponding reference value (e.g., a preset reference value) (S10).

If the controller 130 determines that a short-circuit has occurred, the controller 130 may control the balancing switches S_{B1}, S_{B2}, S_{B3}, ..., and S_{Bn} so that all of the balancing switches S_{B1}, S_{B2}, S_{B3}, ..., and S_{Bn} are immediately turned on (S20).

Due to the short-circuit, the rack fuse F_{R} may blow. If the rack fuse F_{R} blows, electrical connection between the battery 110 and the first pack terminal PT1 is disconnected. In this regard, the pack current may be reduced to about 0. The controller 130 may detect whether the short-circuit has been cleared through the pack current that is equal to or less than the corresponding reference value (e.g., a preset reference value) (S30).

Also, the controller 130 may detect that the short-circuit has occurred due to temporary inrush current. In one or more embodiments, the rack fuse F_{R} does not blow, but the pack current may be reduced to a normal level. The controller 130 may detect that the short-circuit has been cleared through the pack current reduced to the normal level (S30).

The controller 130 may detect a state of the rack fuse F_{R} to determine whether the rack fuse F_{R} blows (S40). If the rack fuse F_{R} does not blow due to the short-circuit, the controller 130 may determine that the short-circuit has not actually occurred, and may control the balancing switches S_{B1}, S_{B2}, S_{B3}, ..., and Ssn so that all of the balancing switches S_{B1}, S_{B2}, S_{B3}, ..., and S_{Bn} are turned off (S50). However, if the rack fuse F_{R} blows due to the short-circuit, the battery pack 100 may not be used until the rack fuse F_{R} is replaced, and the controller 130 may end the protection operation.

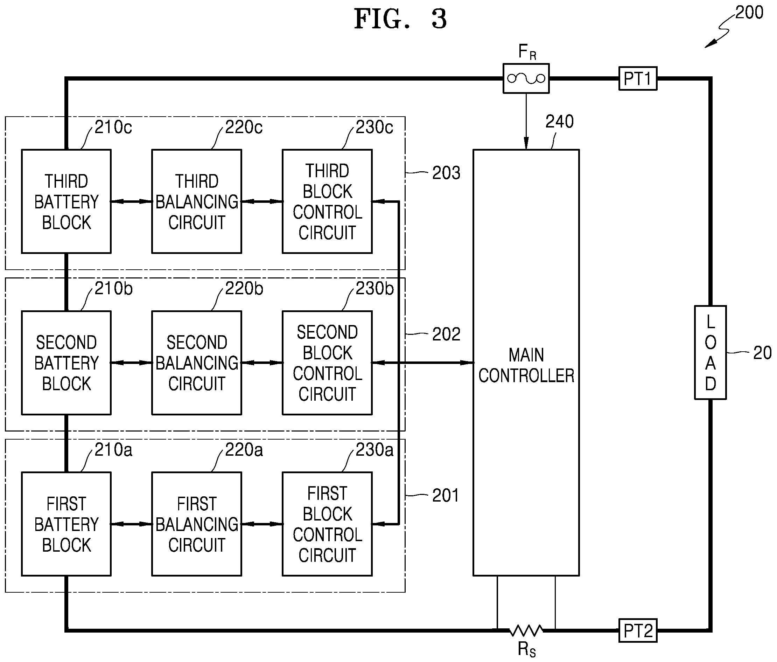

FIG. 3 is a block diagram illustrating a battery pack, according to other embodiments of the present disclosure.

Referring to FIG. 3, a battery pack 200 includes a plurality of blocks (e.g., first to third blocks 201, 202, and 203) and a main controller 240 between first and second pack terminals PT1 and PT2. The battery pack 200 may be connected to a load 20 through the first and second pack terminals PT1 and PT2.

The plurality of blocks (e.g., the first to third blocks 201, 202, and 203) may include first to third battery blocks 210a, 210b, and 210c, first to third balancing circuits 220a, 220b, and 220c, and first to third block control circuits 230a, 230b, and 230c, respectively.

The first to third battery blocks 210a, 210b, and 210c are portions in which power is stored, and may each include a plurality of battery cells. The first to third balancing circuits 220a, 220b, and 220c are circuits for equalizing cell voltages of the battery cells respectively included in the first to third battery blocks 210a, 210b, and 210c. The first to third block control circuits 230a, 230b, and 230c may respectively mange the battery cells of the first to third battery blocks 210a, 210b, and 210c, and may respectively control the first to third balancing circuits 220a, 220b, and 220c.

The battery pack 200 further includes the rack fuse F_{R}. The rack fuse F_{R} may be connected between the first to third battery blocks 210a, 210b, and 210c and the first pack terminal PT1 or the second pack terminal PT2. If current equal to or greater than a corresponding amount (e.g., a preset amount) flows, the rack fuse F_{R} blows to block a high current path through the first to third battery blocks 210a, 210b, and 210c. If the rack fuse F_{R} blows, a relatively large reverse voltage is applied to both ends of the rack fuse F_{R}, but the rack fuse F_{R} has a withstand voltage enough to withstand a relatively large reverse voltage. The main controller 240 may detect a state of the rack fuse F_{R}, and may detect whether the rack fuse F_{R} has blown.

The battery pack 200 includes a current sensor for detecting pack current flowing through the first to third battery blocks 210a, 210b, and 210c. The current sensor may be a shunt resistor Rs between the first to third battery blocks 210a, 210b, and 210c and the second pack terminal PT2 or the first pack terminal PT1.

The main controller 240 may detect a magnitude of pack current based on a voltage at both ends of the shunt resistor Rs. If the main controller 240 detects the pack current exceeding a corresponding reference value (e.g., a preset reference value) by using the shunt resistor Rs, the main controller 240 may determine that a short-circuit has occurred between the first and second pack terminals PT1 and PT2.

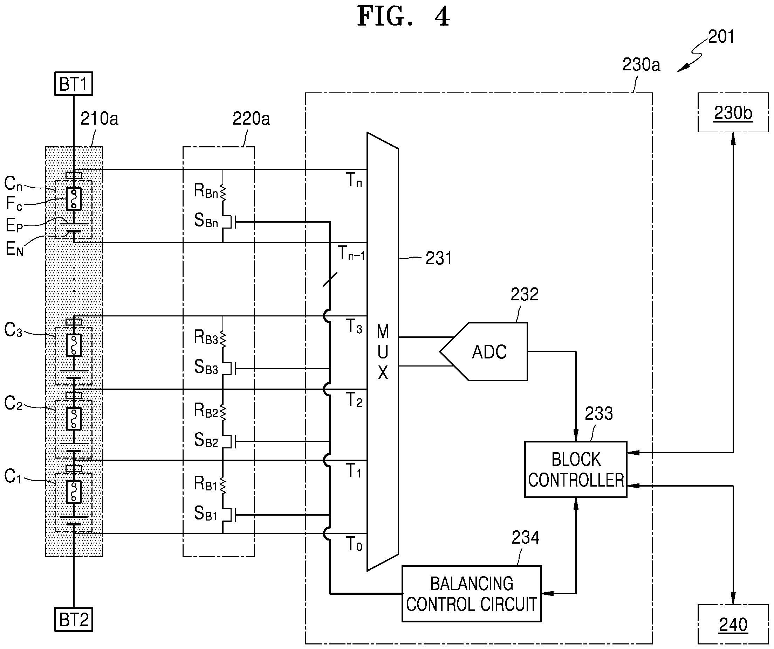

FIG. 4 illustrates one block of the battery pack of FIG. 3.

Referring to FIG. 4 together with FIG. 3, the first block 201 of the battery pack 200 of FIG. 3 is illustrated. The second block 202 and the third block 203 may be substantially the same as the first block 201.

The first battery block 210a may include battery cells C₁, C₂, C₃, ..., and Cₙ. The battery cells C₁, C₂, C₃, ..., and Cₙ may be connected in series between the first and second battery terminals BT1 and BT2 as shown in FIG. 4. Each of the battery cells C₁, C₂, C₃, ..., and Cₙ may be referred to as a battery cell C.

The battery cell C may include an electrode assembly and a cell fuse Fc connected in series between a positive electrode terminal and a negative electrode terminal. The electrode assembly may include a positive electrode E_{P} connected to the positive electrode terminal, a negative electrode E_{N} connected to the negative electrode terminal, and a separator located between the positive electrode E_{P} and the negative electrode E_{N} to separate the positive electrode E_{P} and the negative electrode E_{N} from contacting each other.

If current flows that is equal to or greater than a corresponding amount (e.g., a preset amount), the cell fuse Fc may blow to block a current path through the battery cell C, thereby reducing or preventing a risk of, for example, ignition or explosion of the electrode assembly in the battery cell C.

If a short-circuit occurs between the first and second pack terminals PT1 and PT2 of the battery pack 200 of FIG. 3, relatively large pack current flows between the first and second pack terminals PT1 and PT2. If relatively large pack current flows due to a short-circuit, the rack fuse F_{R} generally blows first. However, If any one of the cell fuses Fc of the battery cells C₁, C₂, C₃, ..., and Cₙ of the first to third battery blocks 210a, 210b, and 210c blows before the rack fuse F_{R}, a reverse voltage exceeding a withstand voltage of the cell fuse Fc is generated at both ends of the cell fuse Fc that blows. This reverse voltage may generate an arc in the cell fuse Fc, and may damage the separator of the battery cell C, causing the positive electrode E_{P} and the negative electrode E_{N} of the electrode assembly to contact each other.

The first balancing circuit 220a includes a plurality of balancing resistors R_{B1}, R_{B2}, R_{B3}, ..., and R_{Bn} and a plurality of balancing switches S_{B1}, S_{B2}, S_{B3}, ..., and S_{Bn} respectively connected to the battery cells C₁, C₂, C₃, ..., and Cₙ. As shown in FIG. 4, a positive electrode terminal and a negative electrode terminal of the first battery cell C₁ are connected to each other through the first balancing resistor R_{B1} and the first balancing switch S_{B1}, which are connected in series. If the first balancing switch S_{B1} is turned on, the first battery cell C₁ and the first balancing resistor R_{B1} form a closed circuit, and both terminals of the first battery cell C₁ are directly connected to both ends of the first balancing resistor R_{B1}.

The first block control circuit 230a may monitor cell voltages and temperatures of the battery cells C₁, C₂, C₃, ..., and Cₙ in the first battery block 210a. The first block control circuit 230a may perform cell balancing for equalizing the cell voltages of the battery cells C₁, C₂, C₃, ..., and Cₙ in the first battery block 210a by using the first balancing circuit 220a. The first block control circuit 230a may be referred to as an analog front end AFE.

The first block control circuit 230a may include battery terminals T₀, T₁, T₂, T₃, ..., Tₙ₋₁, and Tₙ. The battery cells C₁, C₂, C₃, ..., and Cₙ in the first battery block 210a may be connected between the battery terminals T₀, T₁, T₂, T₃, ..., Tₙ₋₁, and Tₙ. For example, the first battery cell C₁ may be connected between the battery terminals T₀ and T₁.

The first block control circuit 230a may include a multiplexer (MUX) 231. The MUX 231 may select two adjacent battery terminals from among the battery terminals T₀, T₁, T₂, T₃, ..., Tₙ₋₁, and Tₙ. The MUX 231 may select two battery terminals connected to any one of the battery cells C₁, C₂, C₃, ..., and Cₙ in the first battery block 210a.

The first block control circuit 230a may include an analog-to-digital converter (ADC) 232. The ADC 232 may convert a voltage between two battery terminals selected by the MUX 231 into a digital value. The ADC 232 may convert a cell voltage of a battery cell selected by the MUX 231 from among the battery cells C₁, C₂, C₃, ..., and Cₙ in the first battery block 210a into a digital value.

The first block control circuit 230a may include a block controller 233. The block controller 233 may receive a digital value output from the ADC 232. The block controller 233 may control the MUX 231 to sequentially select the battery cells C₁, C₂, C₃, ..., and Cₙ in the first battery block 210a one by one, and, in synchronization with this, may receive a digital value output from the ADC 232, to collect all cell voltages of the battery cells C₁, C₂, C₃, ..., and Cₙ.

The first block control circuit 230a may include a balancing control circuit 234. The balancing control circuit 234 may control the balancing switches S_{B1}, S_{B2}, S_{B3}, ..., and S_{Bn} under the control of the block controller 233. The block controller 233 may determine a battery cell that is a candidate for cell balancing from among the battery cells C₁, C₂, C₃, ..., and Cₙ according to a cell-balancing criterion (e.g., a preset cell-balancing criterion). For example, it may be assumed that the first battery cell C₁ is a battery cell that is a candidate for cell balancing. The block controller 233 may control the balancing control circuit 234 to perform cell balancing on the first battery cell C₁, and the balancing control circuit 234 may turn on the first balancing switch S_{B1} corresponding to the first battery cell C₁. Power stored in the first battery cell C₁ may be consumed through the first balancing resistor R_{B1} connected to the first balancing switch S_{B1}, to reduce a cell voltage of the first battery cell C₁.

The main controller 240 may be configured to detect pack current flowing through a battery 210 between the first and second pack terminals PT1 and PT2 through the current sensor, and to control the balancing switches S_{B1}, S_{B2}, S_{B3}, ..., and S_{Bn} of the first to third blocks 201, 202, and 203. The main controller 240 may detect a state of the rack fuse F_{R}. According to the present disclosure, if the main controller 240 detects a short-circuit between the first and second pack terminals PT1 and PT2 based on pack current, to turn on all of the balancing switches S_{B1}, S_{B2}, S_{B3}, ..., and S_{Bn} of the first to third blocks 201, 202, and 203, the main controller 240 may transmit a command to turn on all of the balancing switches to the block controller 233 of the first block 201.

The block controller 233 of the first block 201 may turn on all of the balancing switches S_{B1}, S_{B2}, S_{B3}, ..., and S_{Bn} of the first block 201 according to the command from the main controller 240, and may transmit the command to the block controller 233 of the second block 202. The block controller 233 of the second block 202 may also turn on all of the balancing switches S_{B1}, S_{B2}, S_{B3}, ..., and S_{Bn} of the second block 202 according to the command, and may transmit the command to the block controller 233 of the third block 203. The block controller 233 of the third block 203 may also turn on all of the balancing switches S_{B1}, S_{B2}, S_{B3}, ..., and S_{Bn} of the third block 203 according to the command.

If the rack fuse F_{R} blows first due to a short-circuit, because the rack fuse F_{R} is designed to have a withstand voltage that is higher than a reverse voltage corresponding to a pack voltage, the battery pack 200 may be safely protected. However, even if any one of the cell fuses Fc (e.g., the cell fuse Fc of the first battery cell C₁ of the first block 201) blows before the rack fuse F_{R}, because all of the balancing switches S_{B1}, S_{B2}, S_{B3}, ..., and S_{Bn} are turned on under the control of the main controller 240, a reverse voltage applied to the first battery cell C₁ is applied to both ends of the first balancing resistor R_{B1}, thereby reducing or preventing the likelihood of an arc occurring in the cell fuse Fc of the first battery cell C₁. Even if a short-circuit occurs at a load end of the battery pack 200, the battery pack 200 and a user using the battery pack 200 may be safely protected.

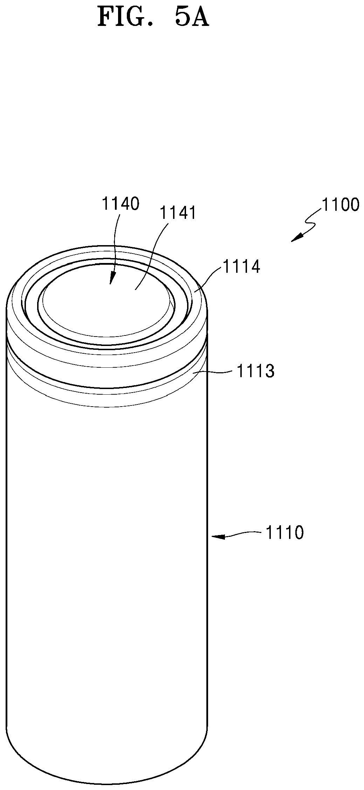

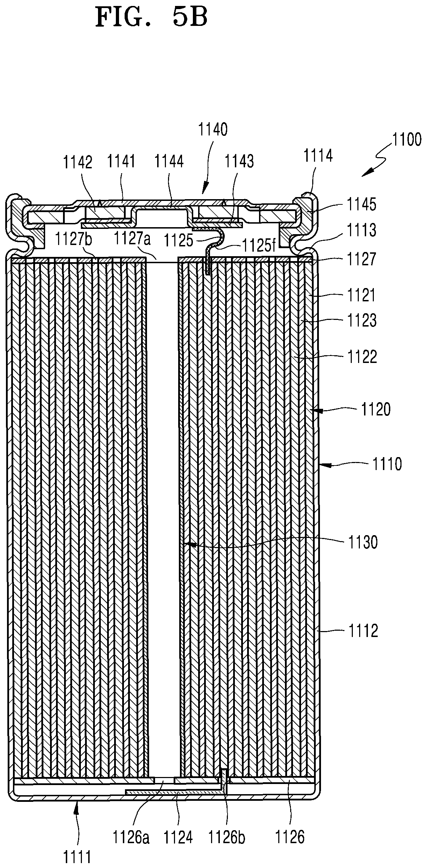

FIGS. 5A and 5B are respectively a perspective view and a cross-sectional view illustrating a cylindrical battery cell mounted on a battery pack, according to embodiments of the present disclosure.

Referring to FIGS. 5A and 5B, a cylindrical battery cell 1100 includes a cylindrical can 1110, an electrode assembly 1120, and a cap assembly 1140. The cylindrical battery cell 1100 may further include a center pin 1130. The cap assembly 1140 performs a current interruption operation in the cylindrical battery cell 1100, and may be referred to as a current interrupt device.

The cylindrical can 1110 may include a bottom portion 1111 having a substantially circular shape, and a cylindrical side wall 1112 extending upwardly from a circumference of the bottom portion 1111. During a process of manufacturing the cylindrical battery cell 1100, an upper portion of the cylindrical can 1110 may be open, and the electrode assembly 1120 and the center pin 1130 may be inserted into the cylindrical can 1110 together with an electrolyte. The cylindrical can 1110 may be formed of, for example, steel, stainless steel, aluminum, an aluminum alloy, or an equivalent thereof.

To reduce or prevent the likelihood of the cap assembly 1140 escaping to the outside, the cylindrical can 1110 may include a beading portion 1113 recessed inwardly at the bottom of a side surface of the cap assembly 1140, and may include a crimping portion 1114 bent inwardly at the top of the side surface of the cap assembly 1140.

The electrode assembly 1120 may be accommodated inside the cylindrical can 1110. The electrode assembly 1120 may include a negative electrode plate 1121 in which a negative electrode active material (e.g., graphite or carbon) is coated on a negative electrode current collector plate, a positive electrode plate 1122 in which a positive electrode active material (e.g., a transition metal oxide, such as LiCoO₂, LiNiO₂, or LiMn₂O₄) is coated on a positive electrode current collector plate, and a separator 1123 located between the negative electrode plate 1121 and the positive electrode plate 1122 to reduce or prevent the likelihood of a short-circuit therebetween while allowing movement of lithium ions therethrough. Also, the negative electrode plate 1121, the positive electrode plate 1122, and the separator 1123 may be wound in a substantially cylindrical shape. For example, the negative electrode current collector plate may be formed of copper (Cu) foil, the positive electrode current collector plate may be formed of aluminum (Al) foil, and the separator may be formed of polyethylene (PE) or polypropylene (PP), but the present disclosure is not limited thereto.

A negative electrode tab 1124 protruding and extending downwardly by a certain length may be welded to the negative electrode plate 1121, and a positive electrode tab 1125 protruding and extending upwardly by a certain length may be welded to the positive electrode plate 1122, or vice versa. The negative electrode tab 1124 may be formed of copper (Cu) or nickel (NI), and the positive electrode tab 1125 may be formed of aluminum (Al), but the present disclosure is not limited thereto.

A cell fuse 1125f may be formed on the positive electrode tab 1125. The cell fuse 1125f is a part of the positive electrode tab 1125, and may be a portion having a width or a thickness that is less than that of other portions of the positive electrode tab 1125. According to one or more other embodiments, a cell fuse may be formed on the negative electrode tab 1124.

The negative electrode tab 1124 of the electrode assembly 1120 may be welded to the bottom portion 1111 of the cylindrical can 1110. In this regard, the cylindrical can 1110 may operate as a negative electrode. In one or more other embodiments, the positive electrode tab 1125 may be welded to the bottom portion 1111 of the cylindrical can 1110, and the cylindrical can 1110 may operate as a positive electrode.

A first insulation plate 1126 may be located between the electrode assembly 1120 and the bottom portion 1111. The first insulation plate 1126 reduces or prevents the likelihood of the electrode assembly 1120 (e.g., the positive electrode plate 1122) electrically contacting the bottom portion 1111. The first insulation plate 1126 may have, or define, a first hole 1126a located at the center, and a second hole 1126b spaced apart from the first hole 1126a. If a large amount of gas is generated due to abnormality of the cylindrical battery cell 1100, the first hole 1126a allows the gas to rapidly move upwardly through the center pin 1130, and the second hole 1126b allows the negative electrode tab 1124 to penetrate therethrough to be welded to the bottom portion 1111.

A second insulation plate 1127 may be located between the electrode assembly 1120 and the cap assembly 1140. The second insulation plate 1127 reduces or prevents the likelihood of the electrode assembly 1120 (e.g., the negative electrode plate 1121) electrically contacting the cap assembly 1140. The second insulation plate 1127 may have a first hole 1127a located at the center, and a plurality of second holes 1127b located outside the first hole 1127a. If a large amount of gas is generated due to abnormality of the cylindrical battery cell 1100, the first hole 1127a allows the gas to rapidly move toward the cap assembly 1140, and one of the plurality of second holes 1127b allows the positive electrode tab 1125 to penetrate therethrough to be welded to the cap assembly 1140. Also, the remaining second holes 1127b allow an electrolyte to rapidly flow into the electrode assembly 1120 in an electrolyte injection process.

Because the first hole 1126a of the first insulation plate 1126 and the first hole 1127a of the second insulation plate 1127 have diameters that are less than a diameter of the center pin 1130, the likelihood of the center pin 1130 electrically contacting either the bottom portion 1111 of the cylindrical can 1110 or the cap assembly 1140 due to external impact is reduced or prevented.

The center pin 1130 has a hollow circular pipe shape, and may be coupled to the center of the electrode assembly 1120. The center pin 1130 may be formed of, for example, steel, stainless steel, aluminum, an aluminum alloy, or polybutylene terephthalate. The center pin 1130 suppresses deformation of the electrode assembly 1120 during charging and discharging of the battery, and functions as a passage through which gas generated inside the cylindrical battery cell 1100 moves. If suitable, the center pin 1130 may be omitted.

The cap assembly 1140 may include a top plate 1141, a middle plate 1142, an insulation plate 1143, and a bottom plate 1144. The middle plate 1142 is located below the top plate 1141, and may have a substantially flat shape. The insulation plate 1143 may be formed in a circular ring shape having a corresponding width if viewed from the bottom. Also, the insulation plate 1143 insulates the middle plate 1142 and the bottom plate 1144 from each other. The insulation plate 1143 may be located between, for example, the middle plate 1142 and the bottom plate 1144 to then be ultrasonically welded, but the present disclosure is not limited thereto.

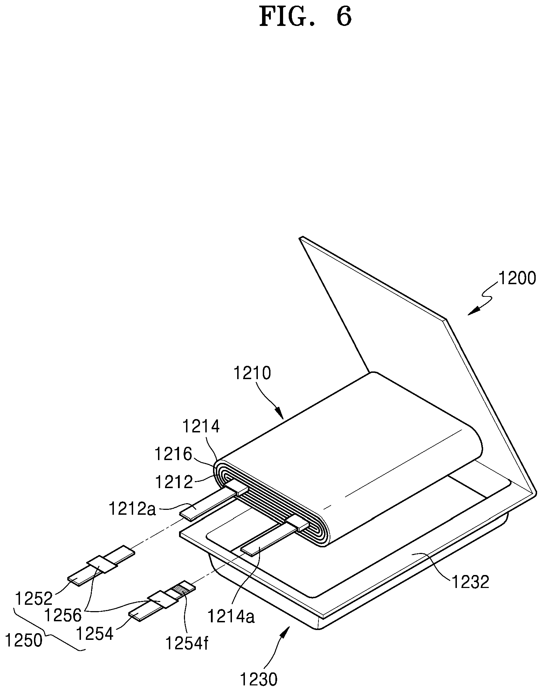

FIG. 6 is a partial perspective view illustrating a structure of a pouch-type battery cell mounted on a battery pack, according to embodiments of the present disclosure.

Referring to FIG. 6, a pouch-type battery cell 1200 includes an electrode assembly 1210, and a pouch 1230 in which the electrode assembly 1210 is accommodated.

The electrode assembly 1210 includes a negative electrode plate 1212 that is a first electrode plate, a positive electrode plate 1214 that is a second electrode plate, and a separator 1216 located between the negative electrode plate 1212 and the positive electrode plate 1214. The negative electrode plate 1212 includes a negative electrode tab 1212a electrically connected to a negative electrode uncoated portion, and the positive electrode plate 1214 includes a positive electrode tab 1214a electrically connected to a positive electrode uncoated portion. The negative electrode tab 1212a and the positive electrode tab 1214a are respectively welded to a negative electrode lead 1252 and to a positive electrode lead 1254 of an external terminal to be electrically connected to the outside. A tab film 1256 for insulation from the pouch 1230 is attached to the negative electrode lead 1252 and to the positive electrode lead 1254.

A cell fuse 1254f may be formed on the positive electrode lead 1254. The cell fuse 1254f is a part of the positive electrode lead 1254, and may be a portion having a width or a thickness less than that of other portions of the positive electrode lead 1254. According to one or more other embodiments, a cell fuse may be formed on the positive electrode tab 1214a. According to one or more other embodiments, a cell fuse may be formed on the negative electrode tab 1212a or the negative electrode lead 1252.

In a state where the electrode assembly 1210 is accommodated in the pouch 1230, sealing portions 1232 of edges of the pouch 1230 contact each other to be sealed. In one or more embodiments, the sealing portions 1232 are sealed in a state where the tab film 1256 is located between the sealing portions 1232. As shown in FIG. 6, a form in which the tab film 1256 is attached to each of the negative electrode tab 1212a and the positive electrode tab 1214a is defined as a "separable tab film." This sealing structure may be defined as a separable sealing structure.

The sealing portions 1232 of the pouch 1230 are formed of a heat-fusible material, and are sealed by adhering heat-fusible layers to each other. Because a heat-fusible material generally has weak adhesion to a metal, the tab film 1256 that is a thin film is attached to a tab to be fused to the pouch 1230. However, in the separable sealing structure, the tab film 1256 may be attached to each tab, welded to the tab, and then heat-fused with the pouch 1230, thereby reducing workability and productivity.

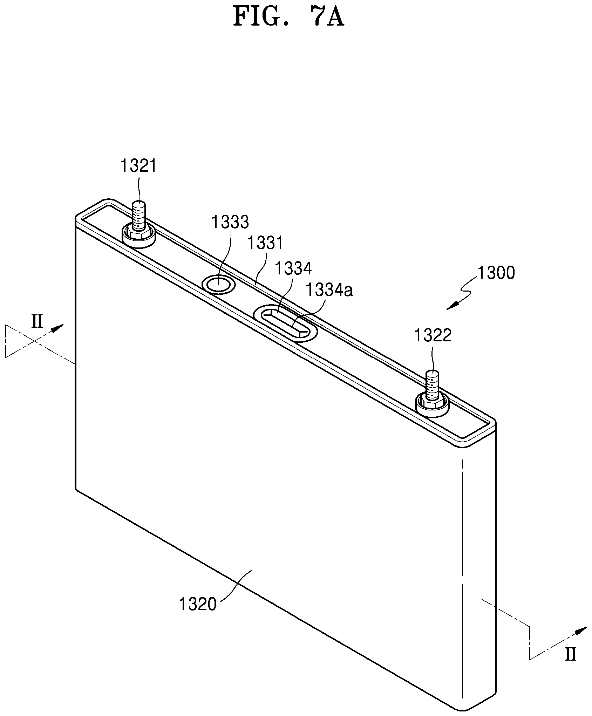

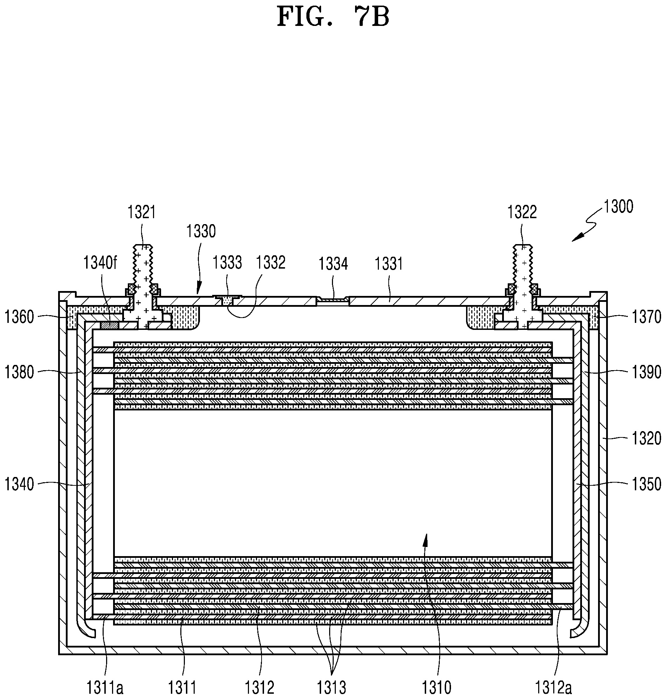

FIG. 7A is a perspective view illustrating a prismatic battery cell mounted on a battery pack, according to embodiments of the present disclosure. FIG. 7B is a cross-sectional view taken along the line II-II of FIG. 7A.

Referring to FIGS. 7A and 7B, a prismatic battery cell 1300 includes at least one electrode assembly 1310 wound with a separator 1313 as an insulator between a positive electrode 1311 and a negative electrode 1312, a case 1320 in which the electrode assembly 1310 is accommodated, and a cap assembly 1330 coupled to an opening of the case 1320.

The prismatic battery cell 1300 is, for example, a prismatic lithium ion battery cell. However, the present disclosure is not limited thereto, and the prismatic battery cell 1300 may be any of various types of battery cells, such as a lithium polymer battery cell.

Each of the positive electrode 1311 and the negative electrode 1312 may include a current collector formed of a thin film metal foil having a coated portion on which an active material is coated, and an uncoated portion 1311a, 1312a on which an active material is not coated.

The positive electrode 1311 and the negative electrode 1312 are wound after interposing the separator 1313, which is an insulator, therebetween. However, the present disclosure is not limited thereto, and the electrode assembly 1310 may have a structure in which a positive electrode and a negative electrode, each of which may be formed of a plurality of sheets, are alternately stacked with a separator therebetween.

The case 1320 may form an overall outer appearance of the prismatic battery cell 1300, and may be formed of a conductive metal, such as aluminum, an aluminum alloy, or nickel-plated steel. Also, the case 1320 may provide a space in which the electrode assembly 1310 is accommodated.

The cap assembly 1330 may include a cap plate 1331 covering the opening of the case 1320, and each of the case 1320 and the cap plate 1331 may be formed of a conductive material. Positive and negative electrode terminals 1321 and 1322 electrically connected to the positive electrode 1311 and the negative electrode 1312 respectively may penetrate the cap plate 1331, and may protrude outwardly.

Outer peripheral surfaces of upper pillars of the positive and negative electrode terminals 1321 and 1322 protruding outwardly from the cap plate 1331 may be threaded and may be fixed to the cap plate 1331 (e.g., with nuts). However, the present disclosure is not limited thereto, and the positive and negative electrode terminals 1321 and 1322 may have a rivet structure, and may be riveted or welded to the cap plate 1331.

The cap plate 1331 may be formed of a thin plate, and may be coupled to the opening of the case 1320, and an electrolyte injection port 1332, into which a sealing stopper 1333 may be provided, may be formed in the cap plate 1331, and a vent portion 1334 having a notch 1334a may be provided.

The positive and negative electrode terminals 1321 and 1322 may be electrically connected to current collectors including first and second current collectors 1340 and 1350 (hereinafter, referred to as positive and negative electrode current collectors) respectively welded to the positive electrode uncoated portion 1311a and the negative electrode uncoated portion 1312a.

For example, the positive and negative electrode terminals 1321 and 1322 may be welded to the positive and negative electrode current collectors 1340 and 1350. However, the present disclosure is not limited thereto, and the positive and negative electrode terminals 1321 and 1322 and the positive and negative electrode current collectors 1340 and 1350 may be integrally formed.

A cell fuse 1340f may be formed on the positive electrode current collector 1340. The cell fuse 1340f is a part of the positive electrode current collector 1340, and may be a portion having a width or a thickness that is less than that of other portions of the positive electrode current collector 1340. According to one or more other embodiments, a cell fuse may be formed on the negative electrode current collector 1350.

Also, an insulation member may be located between the electrode assembly 1310 and the cap plate 1331. The insulation member may include first and second lower insulation members 1360 and 1370, and each of the first and second lower insulation members 1360 and 1370 may be located between the electrode assembly 1310 and the cap plate 1331.

One end of a separation member may face one side surface of the electrode assembly 1310, and may be provided between the insulation member and the positive or negative electrode terminals 1321 and 1322. The separation member may include first and second separation members 1380 and 1390. In this regard, first ends of the first and second separation members 1380 and 1390 provided to face one side surface of the electrode assembly 1310 may be respectively provided between the first and second lower insulation members 1360 and 1370 and the positive and negative electrode terminals 1321 and 1322.

As a result, the positive and negative electrode terminals 1321 and 1322 respectively welded to the positive and negative electrode current collectors 1340 and 1350 may be respectively coupled to first ends of the first and second lower insulation members 1360 and 1370 and the first and second separation members 1380 and 1390.

The implementations shown and described herein are illustrative examples of the present disclosure, and are not intended to otherwise limit the scope of the present disclosure in any way. For the sake of brevity, conventional electronic elements, control systems, software and other functional aspects of the systems may not be described in detail. Also, lines or members connecting elements illustrated in the drawings are merely illustrative of functional connections and/or physical or circuit connections. In an actual device, the connections between elements may be represented by various functional connections, physical connections, or circuit connections that are replaceable or added.

The recitation of ranges of values herein are merely intended to serve as a shorthand method of referring individually to each separate value falling within the range, unless otherwise indicated herein, and each separate value is incorporated into the specification as if it were individually recited herein. Also, operations of all methods described herein may be performed in any suitable order unless otherwise indicated herein or otherwise clearly contradicted by context. The present disclosure is not limited to the order of the operations described.

The use of any and all examples, or exemplary language (e.g., "such as") provided herein, is intended merely to better describe the present disclosure, and does not pose a limitation on the scope of the embodiments unless otherwise claimed. Also, it will be understood by one of ordinary skill in the art that numerous modifications, adaptations, and changes will be made according to design conditions and factors without departing from the scope of the appended claims.

Embodiments have been disclosed herein, and although specific terms are employed, they are used and are to be interpreted in a generic and descriptive sense only and not for purpose of limitation. In some instances, as would be apparent to one of ordinary skill in the art as of the filing of the present application, features, characteristics, and/or elements described in connection with particular embodiments may be used alone or in combination with features, characteristics, and/or elements described in connection with other embodiments unless otherwise specifically indicated. The of the present disclosure is not limited to the above-described embodiments, and all ranges equivalent to the claims or equivalently changed therefrom as well as the claims described below belong to the scope of the present disclosure.

According to the present disclosure, even if a short-circuit occurs at an output end or a load end and a cell fuse blows before a rack fuse, the likelihood of secondary damage caused by a reverse voltage may be reduced or prevented, thereby safely using a battery pack.

However, effects obtainable from the present disclosure may not be limited by the above-mentioned effects. Other unmentioned effects may be clearly understood from the preceding description by one of ordinary skill in the art to which the present disclosure pertains.

It should be understood that embodiments described herein should be considered in a descriptive sense only and not for purposes of limitation. Descriptions of aspects within each embodiment should typically be considered as available for other similar aspects in other embodiments. While one or more embodiments have been described with reference to the figures, it will be understood by those of ordinary skill in the art that various changes in form and details may be made therein without departing from the scope of the present disclosure as defined by the following claims, with functional equivalents thereof to be included therein.

## Claims

1. A battery pack comprising:
battery cells between a first pack terminal and a second pack terminal;
balancing resistors respectively connected to the battery cells;
balancing switches respectively connected to the battery cells and to the balancing resistors, and configured to form a closed circuit by connecting a corresponding one of the battery cells to a corresponding one of the balancing resistors;
a rack fuse between the battery cells and the first pack terminal, or between the battery cells and the second pack terminal;
a current sensor between the battery cells and the first pack terminal, or between the battery cells and the second pack terminal; and
a controller configured to detect pack current between the first pack terminal and the second pack terminal through the current sensor, to control the balancing switches, and to detect a short-circuit between the first pack terminal and the second pack terminal based on the pack current and turn on all of the balancing switches.

2. The battery pack as claimed in claim 1, wherein the battery cells comprise:
a first cell terminal and a second cell terminal;
an electrode assembly comprising a positive electrode connected to the first cell terminal, a negative electrode connected to the second cell terminal, and a separator between the positive electrode and the negative electrode; and
a cell fuse between the electrode assembly and the first cell terminal, or between the electrode assembly and the second cell terminal.

3. The battery pack as claimed in claim 1 or 2, wherein the controller is further configured to detect the short-circuit based on the pack current exceeding a reference value.

4. The battery pack as claimed in claim 1, 2 or 3, wherein the controller is further configured to determine whether the rack fuse blows based on detecting that the short-circuit is cleared in a state where all of the balancing switches are turned on.

5. The battery pack as claimed in claim 3 or any claim dependent on claim 3, wherein the controller is further configured to detect that the short-circuit is cleared based on the pack current being reduced to a level that is equal to or less than the reference value.

6. The battery pack as claimed in any preceding claim, wherein the controller is further configured to turn off all of the balancing switches based on the rack fuse not being blown.

7. The battery pack as claimed in any preceding claim, further comprising:
battery blocks connected between the first pack terminal and the second pack terminal, and comprising corresponding ones of the battery cells;
balancing circuits respectively comprising the balancing resistors and the balancing switches;
block control circuits configured to respectively control the balancing switches; and
a main controller configured to detect the pack current, to detect a state of the rack fuse, and to control the block control circuits.

8. The battery pack as claimed in claim 7, wherein the controller comprises the block control circuits and the main controller.

9. The battery pack as claimed in claim 7 or 8, wherein the main controller is further configured to transmit to the block control circuits a command to turn on all of the balancing switches based on the short-circuit.

10. The battery pack as claimed in claim 7, 8 or 9, wherein the block control circuits are configured to detect cell voltages of the battery cells of a respective one of the battery blocks, and to control the balancing switches of a respective one of the balancing circuits to equalize the cell voltages of the battery cells.

11. A method of protecting a battery pack comprising battery cells between a first pack terminal and a second pack terminal, balancing resistors respectively connected to the battery cells, balancing switches respectively connected to the battery cells and the balancing resistors and configured to form a closed circuit by connecting a corresponding one of the battery cells to a corresponding one of the balancing resistors by turning on, a rack fuse between the battery cells and the first pack terminal or the second pack terminal, a current sensor between the battery cells and the first pack terminal or the second pack terminal, and a controller configured to control the balancing switches, the method comprising:
detecting pack current between the first pack terminal and the second pack terminal through the current sensor;
detecting a short-circuit between the first pack terminal and the second pack terminal based on the pack current; and
turning on all of the balancing switches based on detection of the short-circuit.

12. The method as claimed in claim 11, wherein the detecting of the short-circuit comprises:
comparing the pack current with a reference value; and
determining the pack current exceeds the reference value, and/or
the method further comprises:
detecting the short-circuit is cleared and that all of the balancing switches are turned on; and
determining whether the rack fuse blows.

13. The method as claimed in claim 12, wherein the detecting the short-circuit is cleared comprises:
comparing the pack current with the reference value; and
determining the pack current is reduced to a level equal to or less than the reference value.

14. The method as claimed in claim 12 or 13, further comprising:
determining the rack fuse does not blow; and
turning off all of the balancing switches.

15. The method as claimed in claim any one of claims 11 to 14, wherein the battery cells comprise:
a first cell terminal and a second cell terminal;
an electrode assembly comprising a positive electrode connected to the first cell terminal, a negative electrode connected to the second cell terminal, and a separator between the positive electrode and the negative electrode; and
a cell fuse between the electrode assembly and the first cell terminal or the second cell terminal.
